# EUROPEAN PATENT APPLICATION

(11) **EP 1 482 319 A2**
(43) Date of publication of application: **01.12.2004**
(21) Application number: 04012425.7
(22) Date of filing: 26.05.2004
(51) Int. Cl.: G01R 33/09

(54) **Thin film magnetic sensor and method of manufacturing the same**

(30) Priority: 28.05.2003 JP 2003151523
(71) Applicant: The Foundation: The Research Institute for Electric and Magnetic Materials, Sendai-shi, Miyagi 982-0807 (JP); Daido Steel Co., Ltd., Nagoya-shi, Aichi-ken 460-8581 (JP)
(72) Inventor: Kobayashi, Nobukiyo, Natori-shi Miyagi 981-1245 (JP); Shirakawa, Kiwamu, Sendai-shi Miyagi 982-0021 (JP); Yasushi, Kaneta c/o Daido Steel Co.Ltd R & D lab., Nagoya-shi Aichi-ken 457-8545 (JP)
(74) Representative: Modiano, Guido, Dr.-Ing.

(57) **Abstract**

A thin film magnetic sensor (20) comprises a pair of first thin film yoke (24b) and second thin film yoke (24c) each formed of a soft magnetic material, the first and second thin film yokes being positioned to face each other with a gap (24a) interposed therebetween; a GMR film (26) having an electrical resistivity higher than that of the soft magnetic material and formed in the gap so as to be electrically connected to the first thin film yoke and the second thin film yoke; and an insulating substrate (22) made of an insulating nonmagnetic material and serving to support the first thin film yoke, the second thin film yoke and the GMR film. The GMR film is formed on a facing surface of the first thin film yoke positioned to face the second thin film yoke, and the length of the gap is defined by the thickness of the GMR film positioned on the facing surface of the first thin film yoke.

## Description

### Background of the Invention

### 1. Field of the Invention

The present invention relates to a thin film magnetic sensor and a method of manufacturing the same, and particularly to a thin film magnetic sensor suitable for detection of information on the rotation of an axle of a car, a rotary encoder, and an industrial gear, etc., suitable for detection of information on the stroke position of a hydraulic cylinder or an air type cylinder, and on the position and speed of a slide of a machine tool, suitable for detection of information on the arc current of the industrial welding robot, and suitable for use in a geomagnetism direction sensor, and to a method of manufacturing the particular thin film magnetic sensor.

### 2. Description of the Related Art

A magnetic sensor is an electronic device for converting the detected value of an electromagnetic force such as current, voltage, an electric power, a magnetic field, or a magnetic flux, the detected value of a dynamic quantity such as a position, speed, acceleration, displacement, distance, tension, pressure, torque, temperature, or humidity, and the detected value of the biochemical quantity, into voltage via a magnetic field. A magnetic sensor is classified into, for example, a hole sensor, an anisotropic magnetoresistance (AMR) sensor, and a giant magnetoresistance (GMR) sensor in accordance with the detecting method of a magnetic field.

Among the magnetic sensors noted above, the GMR sensor is advantageous in that:
(1) The GMR sensor has the maximum value in the rate of change of the electrical resistivity, i.e., MR ratio given below, which is markedly larger than that of any of the hole sensor and the AMR sensor: MR ratio = Δρ /ρₒ, where Δρ= ρ_{H} - ρₒ, in which ρ _{H} denotes the electrical resistivity under the external magnetic field H, and ρₒ denotes the electrical resistivity under the condition that the external magnetic field is zero.
(2) The GMR sensor has a change with temperature in the resistance value, which is smaller than that of the hole sensor.
(3) Since the material producing the giant magnetoresistance effect is a thin film material the GMR sensor is suitable for miniaturization of the magnetic sensor.
   Such being the situation, it is expected for the GMR sensor to be used as a high sensitivity micro magnetic sensor in a computer, a power generator, a car, a household electrical appliance, and a portable device.

The materials that are known to exhibit the GMR effect include, for example, (1) a metallic artificial lattice, which is a multilayer film including a ferromagnetic layer such as a layer of Permalloy and a nonmagnetic layer such as a layer of Cu, Ag, or Au, or a multilayer film having a four layer structure, which called a spin valve, the spin valve including an antiferromagnetic layer, a ferromagnetic layer (pinned layer), a nonmagnetic layer, and a ferromagnetic layer (free layer), (2) a metal-metal system nano granular material provided with particulates of a nanometer size formed of a ferromagnetic metal such as Permalloy and with a intergranule consisting of a nonmagnetic metal such as Cu, Ag, or Au, (3) a tunnel junction film that is allowed to exhibit the MR effect by the spindependent tunneling effect, and (4) a metal-insulator system nano granular material provided with particulates of a nanometer size formed of an alloy of a ferromagnetic metal and with a intergranule consisting of a nonmagnetic and insulating material.

Among the materials producing the GMR effect pointed out above, the multilayer film represented by the spin valve is featured in its high sensitivity under a low magnetic field. However, for preparing the multilayer film, it is necessary to laminate thin films made of various materials at a high precision, leading to a poor stability and a low manufacturing yield of the multilayer film. Such being the situation, reduction of the manufacturing cost is limited. Under the circumstances, the multilayer film of this kind is used exclusively in a high value-added device such as a magnetic head for a hard disk. It is considered difficult to use the particular multilayer film in a magnetic sensor that is forced to make competition in price with, for example, the AMR sensor or the hole sensor having a low unit price. It should also be noted that diffusion tends to be generated among the layers forming the multilayer film, and the GMR effect tends to disappear, with the result that the multilayer film is poor in its heat resistance.

On the other hand, the nano granular material can be manufactured easily and has a high reproducibility in general. Therefore, the manufacturing cost of the magnetic sensor can be lowered when the nano granular material is used for the manufacture of the magnetic sensor. Particularly, the metal-insulator system nano granular material is advantageous in that (1) if the composition is optimized, the metal-insulator system nano granular material is allowed to exhibit a high MR ratio exceeding 10% under room temperature, (2) since the metal-insulator system nano granular material exhibits an extremely high electrical resistivity, it is possible to miniaturize markedly the magnetic sensor and to save the power consumption of the magnetic sensor, and (3) the metal-insulator system nano granular material can be used even under a high temperature environment unlike the spin valve films comprising an antiferromagnetic film that is poor in its heat resistance. However, the metal-insulator system nano granular material is defective in that the sensitivity to the magnetic field is very low under a low magnetic field.

A measure for overcoming the problems pointed out above is disclosed in Japanese Patent Disclosure (Kokai) No. 11-087804. Specifically, it is disclosed that soft magnetic thin films are arranged on both sides of a giant magnetoresistance effect thin film in order to increase the sensitivity of the giant magnetoresistance effect thin film to the magnetic field. Also disclosed in the patent document quoted above is a method of manufacturing a thin film magnetic sensor, comprising the steps of forming a permalloy thin film (soft magnetic film) in a thickness of 2 µm on a substrate, forming a gap having a width of about 9 µm in the permalloy thin film by using an ion beam etching apparatus, and forming a nano granular GMR film having a composition of Co_{38.6}Y_{14.0}O_{47.4} in the gap portion.

Japanese Patent Disclosure No. 11-274599 is also directed to a thin film magnetoresistance element in which soft magnetic thin films are arranged on both sides of a giant magnetoresistance thin film. It is taught that, in order to further improve the sensitivity of the magnetoresistance element to the magnetic field, the giant magnetoresistance thin film is made thinner than the soft magnetic thin film.

A soft magnetic material having a large saturation magnetization and a high magnetic permeability has a very high sensitivity to the magnetic field and exhibits a very large magnetization under a relatively weak external magnetic field. Therefore, when an external magnetic field is allowed to act on a thin film magnetic sensor constructed such that a thin film having a high electrical resistivity and producing a giant magnetoresistance effect (GMR film) is arranged in a small gap formed between thin film yokes formed of a soft magnetic material such that the GMR film is electrically connected to the thin film yokes, the thin film yokes are magnetized by a weak external magnetic field, and a magnetic field having an intensity 100 to 10,000 times as high as that of the external magnetic field is exerted on the GMR film. As a result, it is possible to markedly increase the sensitivity of the GMR film to the magnetic field. Incidentally, a metal-insulator system nano granular thin film is known nowadays as the GMR film.

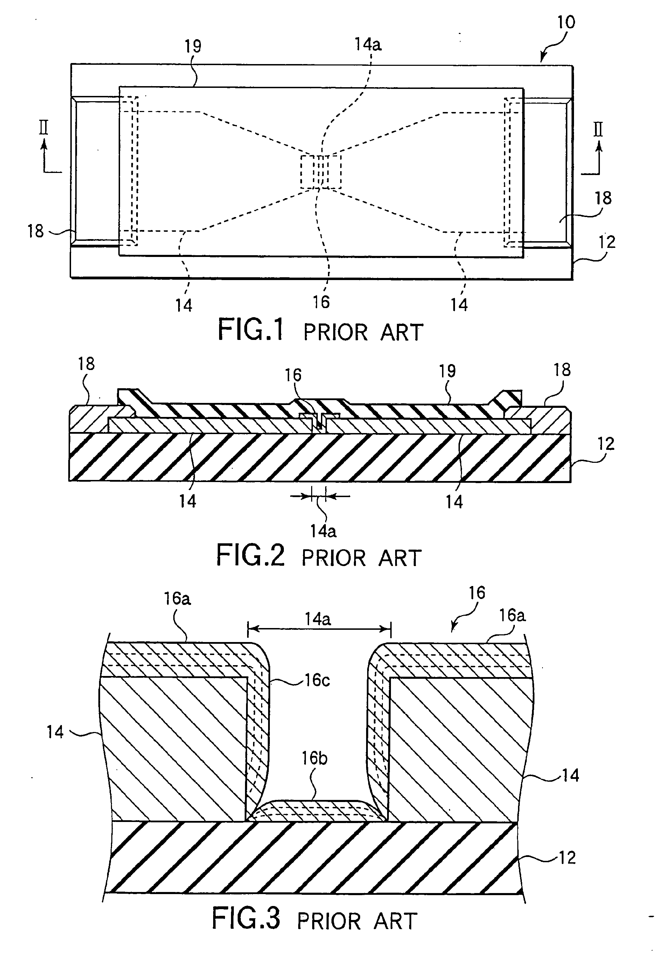

FIG. 1 is a plan view schematically showing the construction of a conventional thin film magnetic sensor 10, and FIG. 2 is a cross sectional view along the line II-II shown in FIG. 1. As shown in FIGS. 1 and 2, the conventional thin film magnetic sensor 10 comprises an insulating substrate 12 made of an insulating and nonmagnetic material, a pair of thin film yokes 14 each formed of a soft magnetic material, the thin film yokes 14 being arranged to face each other with a gap 14a formed therebetween, a GMR film 16 formed within the gap 14a, electrodes 18, 18 formed at the edge portions of the thin film yokes 14, and a protective film 19 for protecting the thin film yokes 14 and the GMR film 16.

The conventional thin film magnetic sensor 10 of the construction described above is formed by the method comprising the steps of forming the pair of the thin film yokes 14 arranged to face each other with the gap 14a (concave groove) interposed therebetween by removing the unnecessary portion of the soft magnetic thin film formed on the surface of the insulating substrate 12, and depositing the GMR film 16 with a mask formed to cover the insulating substrate 12 except the regions in the vicinity of the gap 14a.

However, the thin film magnetic sensor 10 manufactured by the method described above gives rise to the problem that the electrical characteristics and the magnetic characteristics of the sensor 10 greatly varies. The difficulty is brought about by the situation that, in the conventional manufacturing method described above, for example, the electrical contact between the thin film yokes 14 and the GMR film 16 is rendered insufficient, or the thickness of the GMR film 16 is made nonuniform within the gap 14a, with the result that the manufactured sensor 10 is rendered unstable.

FIG. 3 shows the difficulty accompanying the conventional method of manufacturing the thin film magnetic sensor. To be more specific, if the GMR film 16 is deposited from above the thin film yokes 14 positioned to face each other with the small gap 14a interposed therebetween, the thickness in the side wall portions 16c of the GMR film 16, which are formed on the side walls of the thin film yokes 14 having a large height, is gradually increased in accordance with increase in the thickness of the upper portions 16a of the GMR film 16 deposited on the upper surfaces of the thin film yokes 14, as shown in FIG. 3. As a result, the corner portions at the bottom of the gap 14a are shaded by the side wall portions 16c of the GMR film 16 deposited on the side walls of the thin film yokes 14. It follows that the deposition of the GMR film 16 is inhibited at the corner portions in the bottom portion 16b of the GMR film 16, which is deposited on the bottom surface of the gap 14a. Such being the situation, the bottom portion 16b of the GMR film 16 is rendered triangular or trapezoid in its cross sectional shape so as to cause the contact electrical resistance between the bottom portion 16b of the GMR film 16 and the thin film yokes 14 to greatly vary. Particularly, this undesirable phenomenon is rendered prominent in the high performance type thin film magnetic sensor in which the thin film yokes have a large height and the gap between the paired thin film yokes is small. In the worst case, the electrical resistance is rendered infinitely high so as to give rise to a serious obstacle that must be eliminated for putting the thin film magnetic sensor to the practical use.

Further, in order to increase the sensitivity of the GMR film 16 to the magnetic field, it is necessary to suppress the dispersion of the magnetic flux leaking from the thin film yokes 14 into the air atmosphere and to allow the leaking magnetic flux to act efficiently on the GMR film 16. In this sense, it is desirable for the gap 14a to be as short as possible. However, the conventional manufacturing method of the thin film magnetic sensor gives rise to the problem that the deposition of the GMR film 16 inside the gap 14a is further inhibited greatly with decrease in the gap length so as to make it difficult to form the GMR film 16 satisfactorily within the gap 14a.

### Brief Summary of the Invention

An object of the present invention is to provide a thin film magnetic sensor having a very small gap length and a high sensitivity to the magnetic field, and a method of manufacturing a thin film magnetic sensor which permits manufacturing the particular thin film magnetic sensor with a high reproducibility and a low cost.

Another object of the present invention is to provide a thin film magnetic sensor, which comprises a GMR film and thin film yokes made of a soft magnetic material and arranged on both sides of the GMR film and which is capable of suppressing the nonuniformity in the state of the electrical contact between the GMR film and the thin film yokes so as to stabilize the magnetic characteristics, and a method of manufacturing the particular thin film magnetic sensor.

According to a first aspect of the present invention, there is provided a thin film magnetic sensor, comprising:
a pair of first thin film yoke and second thin film yoke each formed of a soft magnetic material, the first and second thin film yokes being positioned to face each other with a gap interposed therebetween;
a GMR film having an electrical resistivity higher than that of the soft magnetic material and formed in the gap so as to be electrically connected to the first thin film yoke and the second thin film yoke; and
an insulating substrate made of an insulating nonmagnetic material and serving to support the first thin film yoke, the second thin film yoke and the GMR film;
wherein the GMR film is formed on a facing surface of the first thin film yoke positioned to face the second thin film yoke, and the length of the gap is defined by the thickness of the GMR film positioned on the facing surface of the first thin film yoke facing the second thin film yoke.

According to a second aspect of the present invention, there is provided a thin film magnetic sensor, comprising a pair of first thin film yoke and second thin film yoke each formed of a soft magnetic material, the first and second thin film yokes being positioned to face each other with a gap interposed therebetween; a GMR film having an electrical resistivity higher than that of the soft magnetic material and formed in the gap so as to be electrically connected to the first thin film yoke and the second thin film yoke; and an insulating substrate made of an insulating nonmagnetic material and serving to support the first thin film yoke, the second thin film yoke and the GMR film; the thin film magnetic sensor being obtained by the steps of:
(a) forming on the surface of the insulating substrate the first thin film yoke made of the soft magnetic material and including a facing surface positioned to face the second thin film yoke;
(b) depositing the GMR film on the facing surface of the first thin film yoke in a manner to permit the GMR film to be electrically connected to the first thin film yoke; and
(c) forming on the surface of the insulating substrate the second thin film yoke made of the soft magnetic material in a manner to permit the second thin film yoke to be electrically connected to the GMR film on the surface of the GMR film.

According to a third aspect of the present invention, there is provided a method of manufacturing a thin film magnetic sensor, comprising the steps of:
forming on the surface of an insulating substrate made of an insulating nonmagnetic material a first thin film yoke made of a soft magnetic material and having a facing surface positioned to face a second thin film yoke that is to be formed later;
depositing on the facing surface of the first thin film yoke a GMR film having an electrical resistivity higher than that of the soft magnetic material in a manner to permit the GMR film to be electrically connected to the first thin film yoke; and
forming the second thin film yoke made of the soft magnetic material on the surface of the insulating substrate in a manner to permit the second thin film yoke to be electrically connected to the GMR film on the surface of the GMR film.

According to the present invention, the GMR film is formed on the facing surface of the first thin film yoke which is positioned to face the second thin film yoke, and the length of the gap is defined by the thickness of the GMR film disposed on the facing surface of the first thin film yoke. It follows that, since the gap length is substantially equal to the thickness of the GMR film, it is possible to make the gap length very small thereby markedly improving the sensitivity to the magnetic field. Since the GMR film is formed on the facing surface of the first thin film yoke which is positioned to face the second thin film yoke and the second thin film yoke is formed so as to be brought into an electrical contact with the GMR film, it is possible to form a sound GMR film. In addition, a face contact can be achieved without fail between the GMR film and the first thin film yoke and between the GMR film and the second thin film yoke so as to ensure a satisfactory electrical contact. It follows that the electric and magnetic characteristics of the thin film magnetic sensor can be stabilized.

Also, in the manufacturing method of the thin film magnetic sensor defined in the present invention, the first thin film yoke is formed first on the surface of an insulating substrate, followed by depositing a GMR film and subsequently depositing the second thin film yoke on the GMR film. It follows that the region in which the GMR film is formed is not positioned between yoke walls having a large height and, thus, a sound electrical connected portion and a good electrical connection can be obtained in the resultant thin film magnetic sensor. In addition, the manufacturing method of the present invention permits manufacturing a thin film magnetic sensor having a high sensitivity to the magnetic field and exhibiting stable magnetic characteristics with a high reproducibility and a low manufacturing cost.

### Brief Description of the Several views of the Drawing

FIG. 1 is a plan view schematically showing the construction of the conventional thin film magnetic field sensor;
FIG. 2 is a cross sectional view along the line II-II shown in FIG. 1;
FIG. 3 is a cross sectional view showing in a magnified fashion the region in the vicinity of the gap included in the conventional thin film magnetic field sensor;
FIG. 4 is a plan view schematically showing the construction of a thin film magnetic sensor according to a first embodiment of the present invention;
FIG. 5 is a cross sectional view along the line V-V shown in FIG. 4;
FIG. 6 is a cross sectional view showing in a magnified fashion the region in the vicinity of the gap included in the thin film magnetic sensor according to the first embodiment of the present invention;
FIGS. 7A to 7V are cross sectional views collectively showing the manufacturing process of the thin film magnetic sensor according to the first embodiment of the present invention;
FIG. 8 is a plan view schematically showing the construction of a thin film magnetic sensor according to a second embodiment of the present invention;
FIG. 9 is a cross sectional view along the line IX-IX shown in FIG. 8;
FIG. 10 is a cross sectional view showing in a magnified fashion the region in the vicinity of the gap included in the thin film magnetic sensor according to the second embodiment of the present invention;
FIGS. 11A to 11O are cross sectional views collectively showing the manufacturing process of the thin film magnetic sensor according to the second embodiment of the present invention;
FIG. 12 is a plan view schematically showing the construction of a thin film magnetic sensor according to a third embodiment of the present invention;
FIG. 13 is a cross sectional view along the line XIII-XIII shown in FIG. 12;
FIG. 14 is a cross sectional view showing in a magnified fashion the region in the vicinity of the gap included in the thin film magnetic sensor according to the third embodiment of the present invention; and
FIGS. 15A to 15O are cross sectional views collectively showing the manufacturing process of the thin film magnetic sensor according to the third embodiment of the present invention.

### Detailed Description of the Invention

Some embodiments of the present invention will now be described in detail with reference to the accompanying drawings.

### First Embodiment

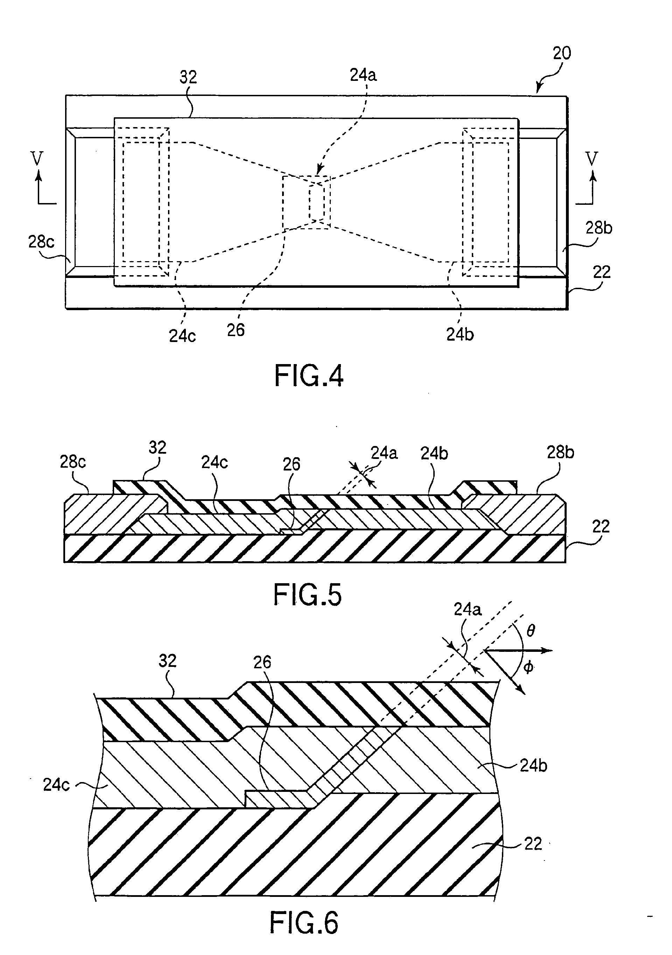

A first embodiment of the present invention will now be described first. FIG. 4 is a plan view schematically showing the construction of a thin film magnetic sensor 20 according to a first embodiment of the present invention, FIG. 5 is a cross sectional view along the line V-V shown in FIG. 4, and FIG. 6 is a cross sectional view showing in a magnified fashion the region in the vicinity of the gap included in the thin film magnetic sensor according to the first embodiment of the present invention. As shown in the drawings, the thin film magnetic sensor 20 comprises an insulating substrate 22, a pair of a first thin film yoke 24b and a second thin film yoke 24c, and a GMR film 26. The pair of the first and second thin film yokes 24b and 24c are formed on the insulating film 22 and positioned to face each other with a gap 24a interposed therebetween. Also, the GMR film 26 is formed in the gap 24a so as to permit the first thin film yoke 24b to be electrically connected to the second thin film yoke 24c. The edge portions of the first thin film yoke 24b and the second thin film yoke 24c are connected to electrodes 28b and 28c, respectively. Further, the uppermost surface of the insulating substrate 22 is covered with a second protective film 32.

The insulating substrate 22, which serves to support the first and second thin film yokes 24b, 24c and the GMR film 26, is formed of an insulating nonmagnetic material. To be more specific, the insulating substrate 22 is formed of a high rigidity material, for example, a glass, an alumina, a silicon covered with a thermally-oxidized film, and an alumina* titanium carbide, which have flattened surface with a insulating film.

The shapes in other portions of the insulating substrate 22 are not particularly limited. It is possible to select optimum shapes in accordance with the use and the required properties of the thin film magnetic sensor 20. Also, only one element comprising the first thin film yoke 24b, the second thin film yoke 24c and the GMR film 26, which is formed on the insulating substrate 22, is shown in each of FIGS. 4 to 6. However, these drawings are simply intended to exemplify the construction of the thin film magnetic sensor 20. In the case of the mass production of the thin film magnetic sensors 20, a plurality of elements are formed simultaneously on one insulating substrate 22.

In order to prevent the fluctuation of the standard potential caused by the temperature, the thin film magnetic sensor generally comprises two elements that are connected in series, and the external magnetic field is detected by measuring the midpoint potential. Also, the thin film magnetic sensor is classified into a perpendicular type in which the two elements are arranged such that the sensitive axes of these two elements are perpendicular to each other, and a parallel type in which the two elements are arranged such that the sensitive axes of these two elements are parallel to each other. Also, in order to double the output, a bridge circuit is formed in some cases by using four elements. In this case, it is possible to form only one element on the insulating substrate 22 and to prepare a magnetic sensor by combining a plurality of the elements each formed on the single insulating substrate 22. Alternatively, it is also possible to form a plurality of elements on the single insulating substrate 22 such that these plural elements are electrically connected to each other.

Each of the first thin film yoke 24b and the second thin film yoke 24c, which are intended to increase the sensitivity of the GMR film 26 to the magnetic field, is formed of a soft magnetic material. In order to obtain a high sensitivity to the magnetic field under a weak magnetic field, it is desirable to use a material having a high magnetic permeability µ and/or a high saturation magnetization Ms for forming the first and second thin film yokes 24b and 24c. To be more specific, it is desirable for the yoke-forming material to have a magnetic permeability µ not lower than 100, preferably not lower than 1,000. It is also desirable for the yoke-forming material to have a saturation magnetization Ms not lower than 5 kilo Gauss, preferably not lower than 10 kilo Gauss.

The specific materials preferably used for forming the first and second thin film yokes 24b and 24c include, for example, permalloy (40 to 90%Ni-Fe alloy), Sendust (Fe₇₄Si₉Al₁₇), Hardperm (Fe₁₂Ni₈₂Nb₆), Co₈₈Nb₆Zr₆ amorphous alloy, (Co₉₄Fe₆)₇₀Si₁₅B₁₅ amorphous alloy, Finemet (Fe_{75.6}Si_{13.2}B_{8.5}Nb_{1.9}Cu_{0.8}), Nanomax (Fe₈₃HF₆C₁₁), Fe₈₅Zr₁₀B₅ alloy, Fe₉₃Si₃N₄ alloy, Fe₇₁B₁₁N₁₈ alloy, Fe_{71.3}Nd_{9.6}O_{19.1} nano granular alloy, Co₇₀Al₁₀O₂₀ nano granular alloy, and Co₆₅Fe₅Al₁₀O₂₀ alloy.

For forming the first thin film yoke 24b, a first thin film made of a soft magnetic material is deposited on the surface of the insulating substrate 22, followed by etching the first thin film thereby forming a facing surface which faces second thin film yoke 24c at the tip of the first thin film.

In the first embodiment of the present invention, the facing surface of the first thin film yoke 24b which is positioned to face the second thin film yoke 24c is formed at one edge surface of the first thin film yoke 24b. It should be noted that the angle θ, hereinafter referred to as an inclination angle θ, made between the facing surface of the first thin film yoke 24b and the main surface of the insulating substrate 22 is larger than 0° and smaller than 90°. In order to obtain a high sensitivity to the magnetic field, it is desirable for the inclination angle θ to be close to 90°. Also, in order to suppress the dispersion of the magnetic flux leaking from the first and second thin film yokes 24b and 24c into the air atmosphere, it is desirable for the distance in the longitudinal direction between the central line of the first thin film yoke 24b and the central line of the second thin film yoke 24c to be short.

In other words, in the first embodiment of the present invention, an inflow angle φ (φ = 90° - θ) is made between the vector having a direction from the side of gap 24a toward the side of the electrode 28b and parallel to the surface of the first thin film yoke 24b and the vector having a direction from the side of the second thin film yoke 24c toward the side of the first thin film yoke 24b and perpendicular to the facing surface (cf. FIG. 6). The inflow angle φ noted above is larger than 0° and smaller than 90°. In order to obtain a high sensitivity to the magnetic field, it is desirable for the inflow angle φ to be close to 0°. Incidentally, it is possible to change optionally the magnitude of the inclination angle θ (or the inflow angle φ) by optimizing the manufacturing conditions described herein later.

On the other hand, the second thin film yoke 24c can be formed by depositing a GMR film 26 in a prescribed thickness on the facing surface of the first thin film yoke, followed by depositing a second thin film made of a soft magnetic material on the surface of the insulating substrate 22 such that the GMR film 26 can be electrically connected to the second thin film yoke 24c on the surface of the GMR film 26 deposited on the facing surface of the first thin film yoke 24b. What should be noted is that the distance between the facing surface of the first thin film yoke 24b and the facing surface of the second thin film yoke 24c, i.e., the gap length of the gap 24a, is substantially equal to the thickness of the GMR film 26. The thin film magnetic sensor according to the first embodiment of the present invention differs in this respect from the conventional thin film magnetic sensor.

The shapes in the other portions of the first thin film yoke 24b and the second thin film yoke 24c are not particularly limited in the present invention. However, in order to increase the sensitivity of the GMR film 26 to the magnetic field, it is desirable for the shapes of the first and second thin film yokes 24b and 24c to satisfy the conditions described in the following.

First of all, it is desirable that the cross sectional area each of the first thin film yokes 24b and 24c on the side of the gap 24a is smaller than that on the each side of the electrodes 28b and 28c each of which acts inflow edge or outflow edge of the external magnetic field. If the cross sectional area of the thin film yoke is made smaller on the side of the gap 24a, the magnetic flux density is increased at the tip of the gap 24a thereby permitting a stronger magnetic field to act on the GMR film 26.

What should also be noted is that it is desirable for each of the first and second thin film yokes 24b and 24c to have an appropriately large L/W ratio, i.e., the ratio of the length L in the gap length direction to the width W on the side of the electrode. Since the demagnetizing field generated in the gap length direction is weakened as the length of each of the first thin film yoke 24b and second thin film yoke 24c is relatively increased in the gap length direction, it is possible to allow the facing surfaces of the thin film yokes 24b and 24c on the side of the electrodes 28b and 28c to perform effectively the function as the inflow and outflow edge of the external magnetic field.

Further, it is desirable for the first thin film yoke 24b and the second thin film yoke 24c to be shaped in symmetry with respect to the gap 24a. It is undesirable for the first thin film yoke 24b and the second thin film yoke 24c to be shaped in asymmetry because the characteristics of the thin film magnetic sensor 20 are governed by the thin film yoke having bad magnetic properties.

Incidentally, the thickness of each of the first and second thin film yokes 24b and 24c is not particularly limited. It is possible to determine appropriately the thickness of the thin film yoke in accordance with, for example, the material of each of the first and second thin film yokes 24b, 24c and the characteristics required for the thin film magnetic sensor 20. Also, in the example shown in FIG. 4, the planar shape of each of the first and second thin film yokes 24b and 24c is tapered on the side of the tip (on the side of the gap 24a). However, it is also possible to form a parallel portion at the tip of each of the first and second thin film yokes 24b and 24c. If a parallel portion is formed at the tip of each of the first and second thin film yokes 24b and 24c, it is possible to suppress the dispersion of the magnetic flux at the tip of each of the first and second thin film yokes 24b and 24c so as to allow a stronger magnetic field to act on the GMR film 26.

The GMR film 26 will now be described. The GMR film 26, which is sensitive to the change of the external magnetic field as the change of the electrical resistance thereby detecting the change of the external magnetic field as a change of the voltage, is formed of a material exhibiting giant magnetoresistance effect. In order to allow the GMR film 26 to detect the change of the external magnetic field with a high sensitivity, it is desirable for the GMR film 26 to have an absolute value of the MR ratio not smaller than 5%, preferably not smaller than 10%, under the condition that the external magnetic field H is not higher than several ten thousand oersteds (Oe).

Also, in the present invention, the GMR film 26 is directly connected electrically to the first thin film yoke 24b and the second thin film yoke 24c. Therefore, a material having an electrical resistivity higher than that of the first thin film yoke 24b and the second thin film yoke 24c is used for forming the GMR film 26. It is undesirable to use a material having an excessively low electrical resistivity for forming the GMR film 26 because, in this case, an electrical short circuit is formed in general between the first thin film yoke 24b and the second thin film yoke 24c. On the other hand, in the case of using a material having an excessively high electrical resistance for forming the GMR film 26, a noise is increased so as to make it difficult to detect the change of the external magnetic field as the change of voltage. It is desirable for the GMR film 26 to exhibit an electrical resistivity falling within a range of between 10³ *µ*Ωcm and 10¹² *µ*Ω cm, preferably between 10⁴ *µ*Ωcm and 10¹¹ µ Ω cm.

The condition given above can be satisfied by various materials. Particularly, the metal-insulator system nano granular material can be used suitably for forming the GMR film 26. In the metal-insulator system nano granular material which exhibits a high MR ratio and a high electrical resistivity, the MR ratio is not greatly changed by a slight change in the composition. It follows that the metal-insulator system nano granular material is advantageous in that it is possible to manufacture a thin film having stable magnetic characteristics with a high reproducibility at a low cost. The metal-insulator system nano granular materials producing a giant magnetoresistance effect and used for forming the GMR film 26 include, for example, Co-Y₂O₃ system nano granular alloy, Co-Al₂O₃ system nano granular alloy, Co-Sm₂O₃ system nano granular alloy, Co-Dy₂O₃ system nano granular alloy, FeCo-Y₂O₃ system nano granular alloy, and fluoride system nano granular alloys such as Fe-MgF₂, FeCo-MgF₂ and Fe-CaF₂.

As described previously, the GMR film 26 is formed on the facing surface at the tip of the first thin film yoke 24b. Therefore, it is desirable to determine appropriately the thickness of the GMR film 26 in accordance with, for example, the material of the GMR film 26 and the characteristics required for the thin film magnetic sensor 20 so as to obtain a required gap length. In order to obtain a high sensitivity to the magnetic field, it is desirable for the GMR film 26 to be as thin as possible, as far as the physical properties of the GMR film 26 are not changed and as far as an electrical short circuit is not generated between the first thin film yoke 24b and the second thin film yoke 24c.

Incidentally, it is possible for the lateral width of the pattern of the GMR film 26 formed after formation of the first thin film yoke 24b to be larger than the lateral width at the tip of each of the first thin film yoke 24b and the second thin film yoke 24c on the side of the gap 24a. Where the GMR film 26 has a large lateral width, the GMR film 26 permits electrically separating the first thin film yoke 24b from the second thin film yoke 24c. In addition, the GMR film 26 performs the function of a protective film for preventing the first thin film yoke 24b from being damaged in forming a pattern of the second thin film yoke 24c. It follows that the large lateral width of the GMR film 26 is advantageous in that a degree of freedom can be provided in the manufacturing process. It should also be noted that, if the lateral width of the GMR film 26 is large, compared with the gap width, the GMR film region sensitive to a weak magnetic flux leaking in the lateral direction of the thin film yoke is enlarged thereby sometimes lowering the sensitivity to the magnetic field. In such a case, it is effective to etch simultaneously the GMR film 26 and the tip portion of the first thin film yoke 24b, which are positioned below the second thin film yoke 24c, after the step of patterning the second thin film yoke 24c, with the second thin film yoke 24c used as the mask of the GMR film 26 and the tip portion of the first thin film 24b. By this particular etching, it is possible to remove the extra portion of the GMR film 26 protruding in the lateral width direction at the tip of the second thin film yoke 24c.

On the other hand, it is possible for the lateral width in that portion of the GMR film 26 which is electrically in contact with both the first thin film yoke 24b and second thin film yoke 24c to be smaller than the lateral width at the tip of the thin film yoke on the side of the gap. In this case, it is necessary to form an additional film made of an insulating nonmagnetic material in that portion of the GMR film 26 which is not brought into an electrical contact with the first thin film yoke 24b and the second thin film yoke 24c in order to electrically separate the first thin film yoke 24b and the second thin film yoke 24c, leading to the defect that the number of manufacturing steps is somewhat increased. However, in the case of decreasing the lateral width in that portion of the GMR film 26 which is electrically in contact with both the first thin film yoke 24b and second thin film yoke 24c, the magnetic flux leaking from the first thin film yoke 24b and the second thin film yoke 24c is unlikely to be dispersed in the direction of the lateral width so as to produce the advantage that the sensitivity to the magnetic field is improved.

Each of the electrodes 28b and 28c, which serve to take out the output, is formed of a conductive material. To be more specific, it is desirable to use, for example, Cu, Ag or Au for forming the electrodes 28b and 28c. The shapes of the electrodes 28b and 28c are not particularly limited. It is possible to determine appropriately the shapes of the electrodes 28b and 28c in accordance with, for example, the size of the thin film magnetic sensor 20 and the shapes of the first and second thin film yokes 24b and 24c.

The second protective film 32 serves to shield the GMR film 26 exposed to the surface of the insulating substrate 22 as well as the first thin film yoke 24b and the second thin film yoke 24c from the outer air so as to protect these members of the thin film magnetic sensor 20. Also, an insulating nonmagnetic film is used for forming the second protective film 32. To be more specific, it is desirable to use, for example, Al₂O₃, SiO₂, Si₃N₄ or a photoresist subjected to a hard baking under temperatures not lower than 200°C for forming the second protective film 32.

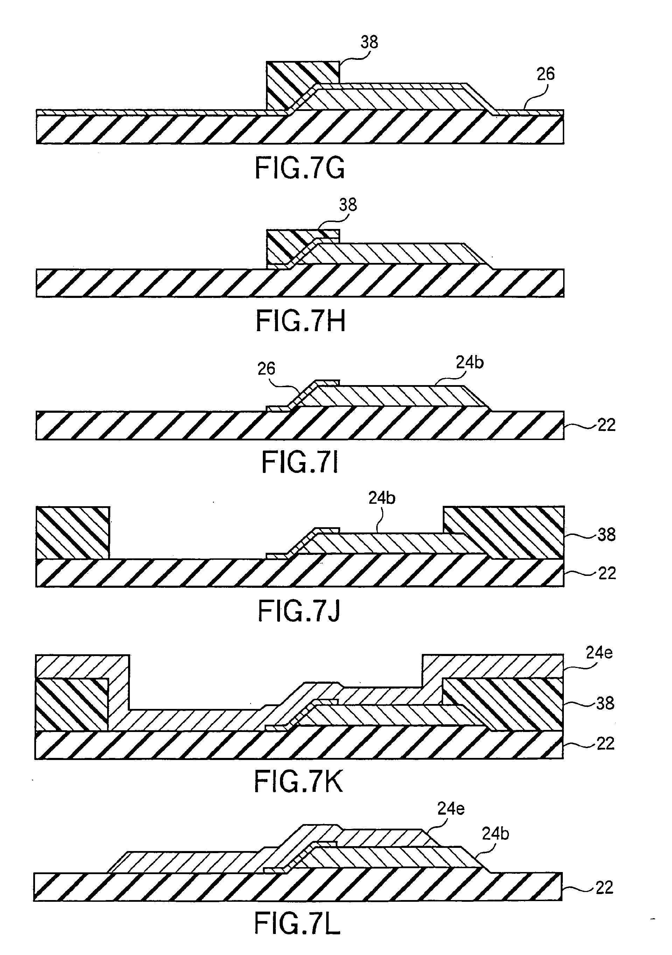

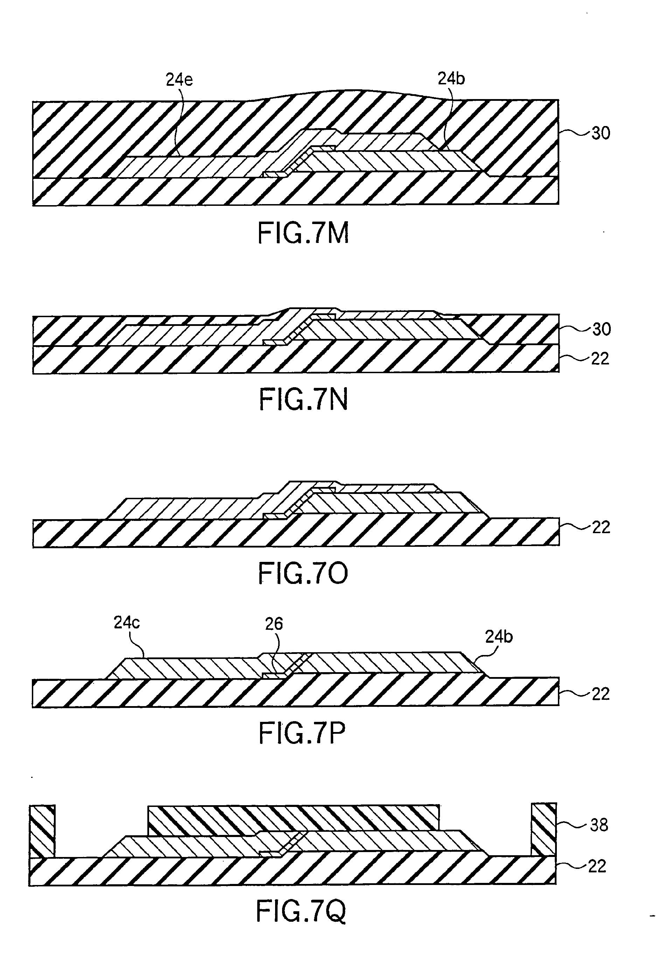

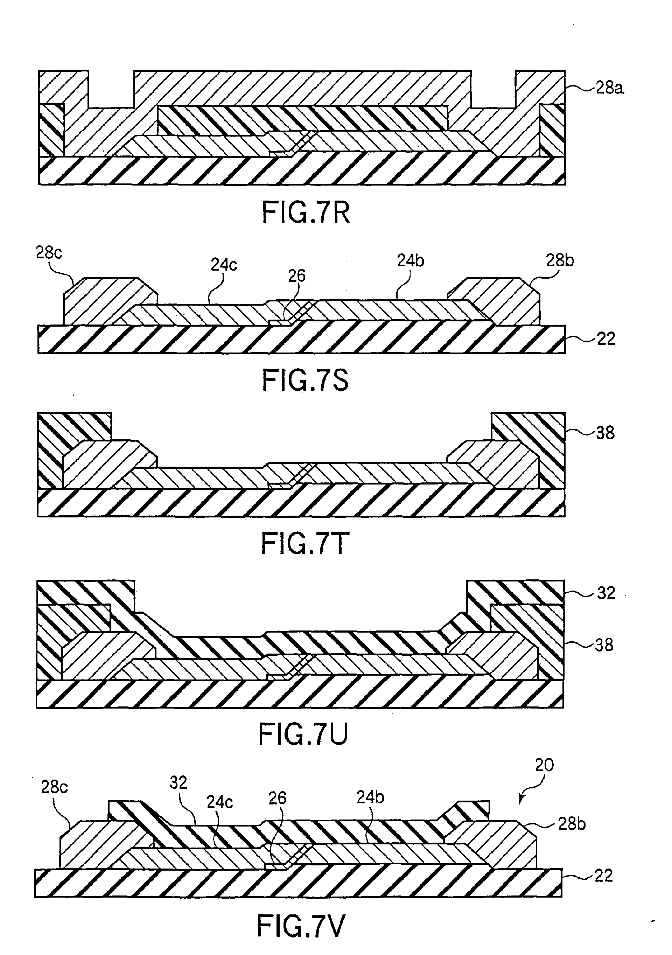

A method of manufacturing the thin film magnetic sensor 20 according to the first embodiment of the present invention will now be described. FIGS. 7A to 7V are cross sectional views collectively showing the manufacturing process of the thin film magnetic sensor 20 according to the first embodiment of the present invention. The manufacturing process of the thin film magnetic sensor 20 according to the first embodiment of the present invention comprises the step of forming a first thin film yoke, the step of forming a GMR film, the step of forming a second thin film yoke, the step of forming an electrode, and the step of forming a surface protective film.

The step of forming the first thin film yoke will now be described first. In the step of forming the first thin film yoke, a first thin film 24d of a soft magnetic material (hereinafter referred to as a first soft magnetic thin film) is deposited on the surface of the insulating substrate 22 consisting of an insulating nonmagnetic material, followed by forming the first thin film yoke 24b of the soft magnetic material and including the facing surface facing the second thin film yoke 24c.

To be more specific, it is desirable for the step of forming the first thin film yoke to be carried out as follows. In the first step, a soft magnetic thin film 24d is formed on the entire surface of the insulating substrate 22, as shown in FIG. 7A. Then, the first soft magnetic thin film 24d is coated with a photoresist material 37, followed by arranging a mask 36 provided with a prescribed open portion above the insulating substrate 22 for the light exposure treatment, as shown in FIG. 7B. Further, the sensitized portion is removed by the developing so as to form a photoresist film 38 in the portion where the first thin film yoke 24b is to be formed, as shown in FIG. 7C.

In this case, it is desirable to apply a post baking to the photoresist film 38 at 80 to 120°C for 0.05 to 1.0 hour after formation of the photoresist film 38. In the case of applying the post baking, the solvent is evaporated from the photoresist film 38 and, thus, the photoresist film 38 is shrunk to some extent so as to make it possible to impart a gradient to the side surface of the photoresist film 38. Where the side surface of the photoresist film 38 is somewhat inclined, the shading is unlikely to be generated in the etching step, leading to the advantage that the first soft magnetic thin film 24d can be etched efficiently.

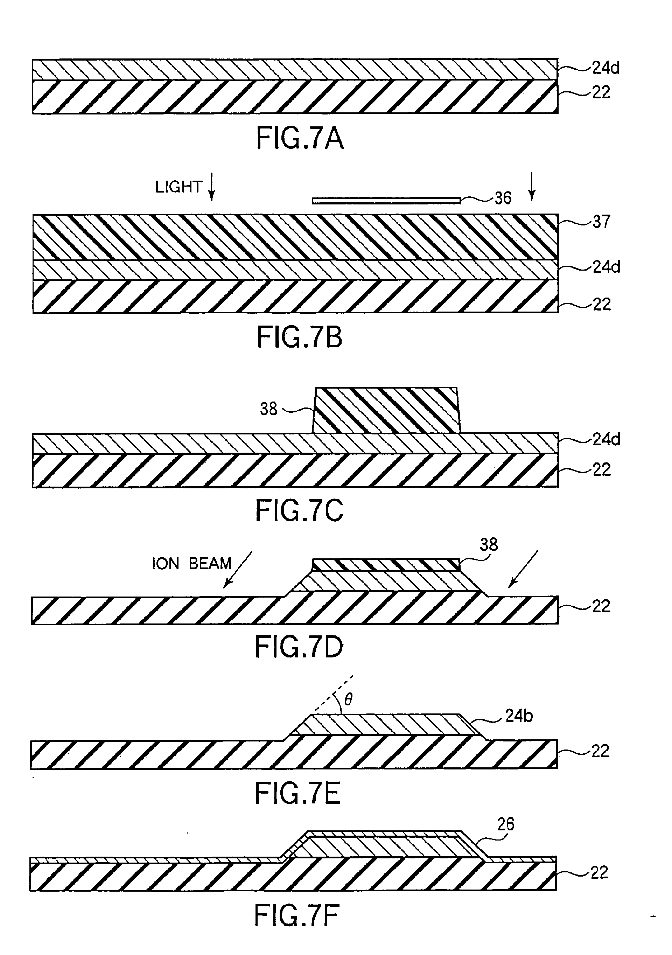

In the next step, an Ar ion beam etching is carried out while rotating the insulating substrate 22, as shown in FIG. 7D. If the irradiating conditions such as the rotating speed of the insulating substrate 22 and the irradiating angle of the Ar ion beam are optimized in this etching step, it is possible to etch obliquely the first soft magnetic thin film 24b along the boundary line of the photoresist film 38 such that the edge surface of the etched first soft magnetic thin film 24d has a prescribed inclination angle θ, as shown in FIG. 7D.

After the Ar ion beam etching is continued until the undesired portion of the first soft magnetic thin film 24d is removed completely, the photoresist film 38 remaining on the first soft magnetic thin film 24d is removed (peeled off) so as to obtain the first thin film yoke 24b including the facing surface having a prescribed inclination angle θ, as shown in FIG. 7E.

The step of forming the GMR film will now be described. In the step of forming the GMR film, the GMR film 26 is formed on the facing surface of the first thin film yoke 24b. To be more specific, it is desirable for the step of forming the GMR film to be carried out as follows. In the first step, the GMR film 26 having a prescribed composition is deposited in a prescribed thickness on the entire surface of the insulating substrate 22 having the first thin film yoke 24b formed thereon such that the MGR film 26 is electrically connected to the first thin film yoke 24b, as shown in FIG. 7F. Then, a photoresist film 38 is formed in the portion where the GMR film 26 is to be left unremoved as shown in FIG. 7G by the method similar to the method described previously in conjunction with the step of forming the first thin film yoke.

Further, an Ar ion beam etching is performed under prescribed conditions while rotating the insulating substrate 22 so as to remove the unnecessary portion of the GMR film 26, as shown in FIG. 7H. After completion of the etching, the residual photoresist film 38 is removed (peeled off) so as to form the GMR film 26 on the facing surface of the first thin film yoke 24b and on the surface in the vicinity of the facing surface noted above, as shown in FIG. 7I. The etching performed in this case is not limited to the Ar ion beam etching. It is also possible to employ a wet etching or a reactive ion etching (RIE) exhibiting a good etching selectivity ratio relative to the other films. On the other hand, it is also possible to employ a lift-off method, in which an opening is formed in the portion where the GMR film 26 is to be left unremoved and the photoresist film 38 is formed in the remaining portion, followed by depositing the GMR film 26 and subsequently removing the photoresist film 38 together with the extra portion of the GMR film 26.

Incidentally, where the lateral width of the GMR film 26 is larger than the lateral width of the facing surface of the first thin film yoke 24b, the GMR film 26 prevents the direct connection between the first thin film yoke 24b and the second thin film yoke 24c. Therefore, in this case, the manufacturing process proceeds to the next step so as to form the second thin film yoke 24c directly on the GMR film 26.

On the other hand, where the lateral width of the GMR film 26 is made smaller than the lateral width of the facing surface of the first thin film yoke 24b, a thin film consisting of an insulating nonmagnetic material is deposited on both sides of the GMR film 26 and, then, formed into a prescribed shape by, for example, a lift-off method before formation of the second thin film yoke 24c so as to prevent the direct contact between the first thin film yoke 24b and the second thin film yoke 24c. It is also possible to deposit the GMR film 26 having a lateral width larger than the lateral width of the facing surface of the first thin film yoke 24b on the facing surface of the first thin film yoke 24b, followed by covering a part of the GMR film 26 with a thin film of an insulating nonmagnetic material so as to decrease the lateral width in that portion of the GMR film 26 which is brought into contact with the second thin film yoke 24c.

The step of forming the second thin film yoke will now be described. In the step of forming the second thin film yoke, a second thin film 24e of a soft magnetic material (hereinafter referred to as a second soft magnetic thin film) is deposited on the insulating substrate 22 such that the GMR film 26 is electrically connected to the second thin film yoke 24c on the surface of the GMR film 26 deposited on the facing surface of the first thin film yoke 24b so as to form the second thin film yoke 24c of the soft magnetic material. To be more specific, it is desirable for the step of forming the second thin film yoke 24c to be carried out as follows.

In the first step, a photoresist film 38 is formed on the surface of the insulating substrate 22 excluding the portion where the second thin film yoke 24c is formed, as shown in FIG. 7J. The photoresist film 38 is formed by the method similar to that described previously in conjunction with the step of forming the first thin film yoke. In this case, it is desirable for the photoresist film 38 to be formed such that a second soft magnetic thin film 24e that is to be newly deposited is also deposited on the first thin film yoke 24b that was already formed on the insulating substrate 22.

In the next step, the second soft magnetic thin film 24e is deposited in a prescribed thickness on the entire surface of the insulating substrate 22, as shown in FIG. 7K. Further, the photoresist film 38 is removed (peeled off) so as to obtain the second soft magnetic thin film 24e that is electrically connected to both the first thin film yoke 24b and the GMR film 26 formed on the facing surface of the first thin film yoke 24b, as shown in FIG. 7L. It is also possible to obtain the similar structure by depositing the second soft magnetic thin film 24e on the entire surface under the state shown in FIG. 7I, followed by forming a photoresist mask for forming the shape of the second thin film yoke and subsequently removing the unnecessary portion of the second soft magnetic thin film 24e by the Ar ion etching.

Then, the unnecessary portion of the second soft magnetic thin film 24e which is in direct contact with the first thin film yoke 24b is removed thereby forming the second thin film yoke 24c. It is desirable for the unnecessary portion of the second soft magnetic thin film 24e to be removed as follows.

In the first step, a first protective film 30 of an insulating nonmagnetic material is deposited in a prescribed thickness on the entire surface of the insulating substrate 22, as shown in FIG. 7M. The first protective film 30 is intended to protect the first thin film yoke 24b and the second soft magnetic thin film 24e in removing the unnecessary portion of the second soft magnetic thin film 24e and to planarize the underlying structure. Also, an appropriate material is selected in forming the first protective film 30 in accordance with the method of removing the unnecessary portion of the second soft magnetic thin film 24e.

The unnecessary portion of the second soft magnetic thin film 24e is removed until the second soft magnetic thin film 24e ceases to be in direct contact with the first thin film yoke 24b. The method of removing the unnecessary portion of the second soft magnetic thin film 24e, which is protected by the first protective film 30, is not particularly limited, and various methods can be employed for removing the unnecessary portion. To be more specific, it is desirable to employ the method described in the following.

A first method is a mechanical polishing method in which, after formation of the first protective film 30 on the entire surface of the insulating substrate 22, the surface of the insulating substrate 22 is mechanically polished until the second soft magnetic thin film 24e deposited on the first thin film yoke 24b is removed completely. In this case, it is desirable for the first protective film 30 to be formed of, for example, an Al₂O₃ film, a SiO₂ film, a post baked photoresist film, or a photoresist film that is hard baked under temperatures not lower than 200°C.

A second method is an etch back method in which, after formation of the first protective film 30 on the entire surface of the insulating substrate 22, the surface of the insulating substrate 22 is etched with an ion beam. In this case, it is desirable for the first protective film 30 to be formed of a photoresist film that is pre-baked under temperatures not higher than 90°C or post baked under temperatures of 90 to 120°C for one hour.

If an etching is applied after formation of the photoresist film (first protective film 30) on the surface of the insulating substrate 22 as shown in FIG. 7M, the photoresist film alone is etched first. With progress of the etching, the convex portion of the second soft magnetic thin film 24e is caused to be exposed to the surface of the photoresist film. Then, the photoresist film and the convex portion of the second soft magnetic thin film 24e are etched simultaneously.

In general, the surface of the photoresist film is not rendered completely flat. In addition, there is a difference in the etching rate between the second soft magnetic thin film 24e and the photoresist film. Such being the situation, it is difficult to remove completely the unnecessary portion of the second soft magnetic thin film 24e by a single etching operation. Under the circumstances, the etching is once stopped before the photoresist film is completely removed as shown in FIG. 7N, followed by removing (peeling off) the photoresist film as shown in FIG. 70. The operations including (1) formation of the photoresist film, followed by pre-baking or post baking of the photoresist film, (2) etching, and (3) removing (peeling off) of the photoresist film are repeated a prescribed number of times until the second soft magnetic thin film 24e deposited on the first thin film yoke 24b is completely removed.

Incidentally, it is advisable to carry out the etching somewhat excessively in the case where the lateral width of the GMR film 26 is larger than the lateral width at the tip of the first thin film yoke 24b on the side of the gap at the time when the GMR film 26 is formed on the facing surface of the first thin film yoke 24b. If the etching is carried out somewhat excessively in this case, it is possible to remove the extra GMR film 26 protruding in the direction of the lateral width at the tip of the second thin film yoke 24c, with the second thin film yoke 24c used as a mask.

If the unnecessary portion of the second soft magnetic thin film 24e, which is in direct contact with the first thin film yoke 24b, is completely removed by, for example, the mechanical polishing method or the etch back method, it is possible to obtain the first thin film yoke 24b including the facing surface having a prescribed inclination angle θ, the GMR film 26 deposited on the facing surface of the first thin film yoke 24b, and the second thin film yoke 24c that is electrically connected to the GMR film 26 alone on the surface of the GMR film 26, as shown in FIG. 7P.

The step of forming the electrode will now be described. The electrodes 28b and 28c are formed in the edge portions of the first thin film yoke 24b and the second thin film yoke 24c, respectively, in the step of forming the electrode. To be more specific, a photoresist film 38 is newly formed on the insulating substrate 22 excluding the regions in which the electrodes 28b, 28c are to be formed, as shown in FIG. 7Q. The photoresist film 38 is formed by the method similar to that described previously in conjunction with the step of forming the first thin film yoke. Then, a thin film 28a having a prescribed thickness and formed of an electrically conductive material is deposited from above the photoresist film 38, as shown in FIG. 7R, followed by removing (lifting off) the photoresist film 38. As a result, it is possible to form the electrodes 28b and 28c in the edge portions of the first thin film yoke 24b and the second thin film yoke 24c, respectively, as shown in FIG. 7S.

The step of forming the surface protective film will now be described. A second protective film 32 serving to protect the first thin film yoke 24b, the second thin film yoke 24c, and the GMR film 26 is formed on the uppermost surface of the insulating substrate 22 in the step of forming the surface protective film. To be more specific, a photoresist film 38 is newly formed on the insulating substrate 22 excluding the region in which the second protective film 32 is to be formed, as shown in FIG. 7T. The photoresist film 38 is formed by the method described previously in conjunction with the step of forming the first thin film yoke. In this case, it is advisable to form the photoresist film 38 such that the electrode 28 is partly covered with the second protective film 32. Then, a second protective film 32 is deposited in a prescribed thickness from above the photoresist film 38 as shown in FIG. 7U, followed by removing (lifting off) the photoresist film 38. As a result, obtained is the thin film magnetic sensor 20 according to the first embodiment of the present invention, as shown in FIG. 7V.

The function and effect of the thin film magnetic sensor 20 according to the first embodiment of the present invention will now be described. As described previously, the conventional method of manufacturing the thin film magnetic sensor comprises depositing a soft magnetic thin film on the surface of an insulating substrate, forming a concave groove (gap) having a small width in the soft magnetic thin film thus formed so as to obtain thin film yokes positioned to face each other with the small gap interposed therebetween, and depositing a GMR film on the thin film yokes including the gap.

In the conventional method described above, however, the cross sectional shape of bottom portion of the GMR film formed within the gap is rendered triangular or trapezoid. As a result, the contact area between the side wall portion of the GMR film and the bottom portion of the GMR film is rendered markedly smaller than the average cross sectional area in the thickness direction of the GMR film. In the extreme case, the side wall portion and the bottom portion of the GMR film are brought into a linear contact. It follows that the contact electrical resistance between the thin film yoke and the GMR film is markedly changed by a slight change in the manufacturing conditions. In addition, the magnetic characteristics of the thin film magnetic sensor are rendered unstable.

Also, the metal-insulator system nano granular material, which is excellent in the magnetic characteristics, is brittle and, thus, when deposited within the gap so as to form a thin film, the film tends to be cracked along the boundary line between the thin film portion growing from the planar bottom portion of the gap and the thin film portion growing from the side wall of the gap. It follows that, in the case of using the metal insulator system nano granular material as the GMR film of the thin film magnetic sensor and deposited the material within the gap, the thin film magnetic sensor tends to be rendered very unstable both electrically and magnetically.

On the other hand, in the thin film magnetic sensor 20 according to the first embodiment of the present invention, the first thin film yoke 24b alone is deposited first in forming the first thin film yoke 24b and the second thin film yoke 24c, which are positioned to face each other. It follows that the region in which the GMR film 26 is deposited is not positioned between high side walls of the thin film yokes.

Such being the situation, it is possible to form the sound GMR film 26 free from the cracking on the facing surface of the first thin film yoke 24b. It should also be noted that a face contact is achieved without fail between the GMR film 26 and the first thin film yoke 24b and between the GMR film 26 and the second thin film yoke 24c on the surface of the GMR film 26 thereby improving the magnetic characteristics of the thin film magnetic sensor 20.

In addition, in the thin film magnetic sensor 20 thus manufactured, the gap length is determined by the thickness of the GMR film 26, with the result that the magnetic flux generated from the first thin film yoke 24b and the second thin film yoke 24c acts effectively on the GMR film 26 so as to suppress the magnetic flux leaking into the air atmosphere. Under the circumstances, the thin film magnetic sensor 20 exhibits a very high ideal sensitivity to the magnetic field, compared with the conventional thin film magnetic sensor.

### Second Embodiment

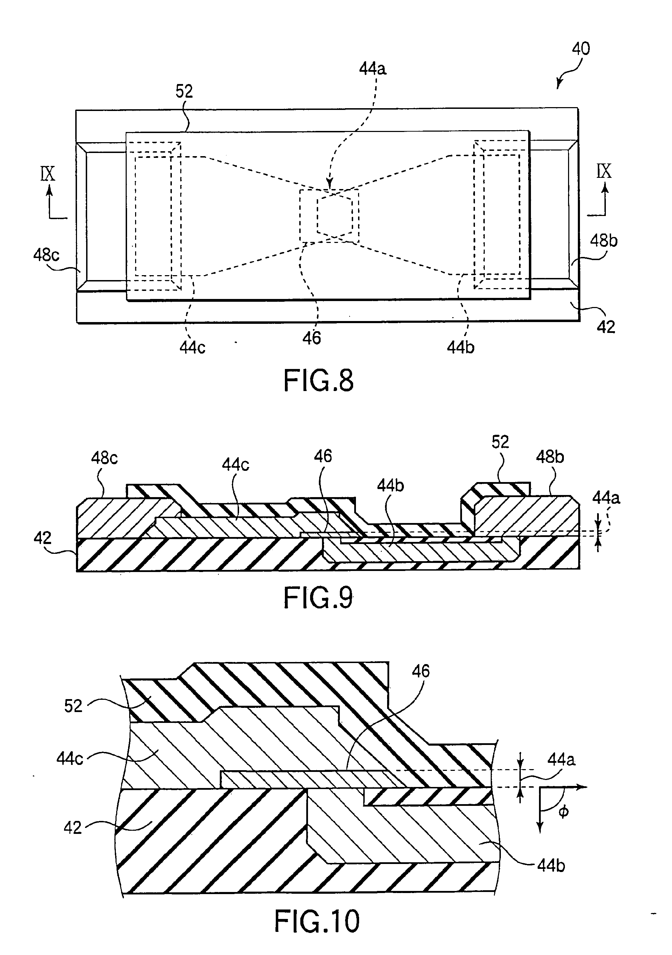

A thin film magnetic sensor according to a second embodiment of the present invention will now be described. FIG. 8 is a plan view schematically showing the construction of a thin film magnetic sensor 40 according to a second embodiment of the present invention, FIG. 9 is a cross sectional view along the line IX-IX shown in FIG. 8, and FIG. 10 is a cross sectional view showing in a magnified fashion the region in the vicinity of the gap included in the thin film magnetic sensor according to the second embodiment of the present invention.

As shown in the drawings, the thin film magnetic sensor 40 comprises an insulating substrate 42, a pair of a first thin film yoke 44b and a second thin film yoke 44c positioned to face each other with a gap 44a interposed therebetween, and a GMR film 46 formed in the gap 44a so as to be electrically connected to both the first thin film yoke 44b and the second thin film yoke 44c. Electrodes 48b and 48c are connected to the edge portions of the first thin film yoke 44b and the second thin film yoke 44c, respectively, and the uppermost surface of the insulating substrate 42 is covered with a second protective film 52.

The thin film magnetic sensor 40 according to the second embodiment of the present invention is featured in that the facing surface of the first thin film yoke 44b, i.e., the edge surface facing the second thin film yoke 44c, is parallel to the surface of the insulating substrate 42. In other words, the facing surface is formed on the side of the upper surface of the first thin film yoke 44b. Also, the inclination angle θ of the facing surface of the first thin film yoke 44b is 0°, i.e., the inflow angle φ is 90°.

Incidentally, the insulating substrate 42, the first thin film yoke 44b, the second thin film yoke 44c, the GMR film 46, the electrodes 48b and 48c, the second protective film 52 and the other members are equal to the insulating substrate 22, the first thin film yoke 24b, the second thin film yoke 24c, the GMR film 26, the electrodes 28b and 28c, the second protective film 32 and the other members included in the thin film magnetic sensor 20 according to the first embodiment of the present invention and, thus, the description of the insulating substrate 42, etc. is omitted.

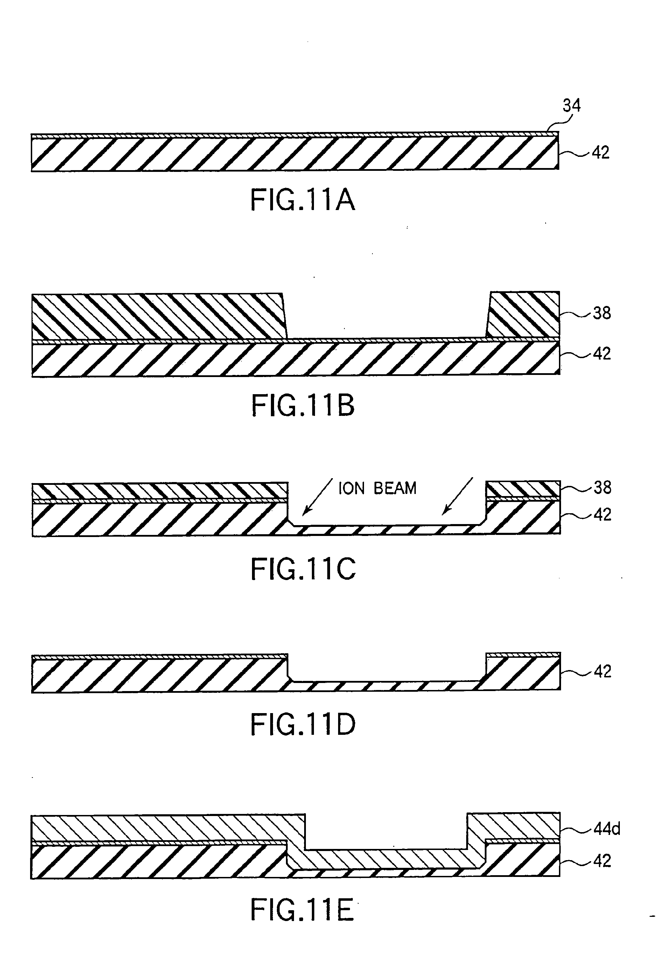

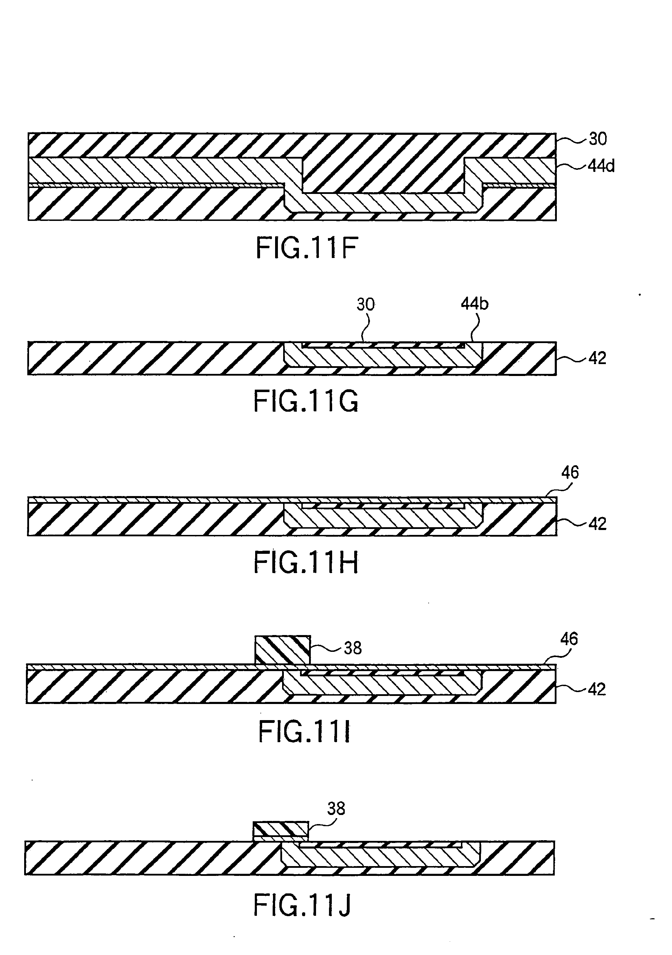

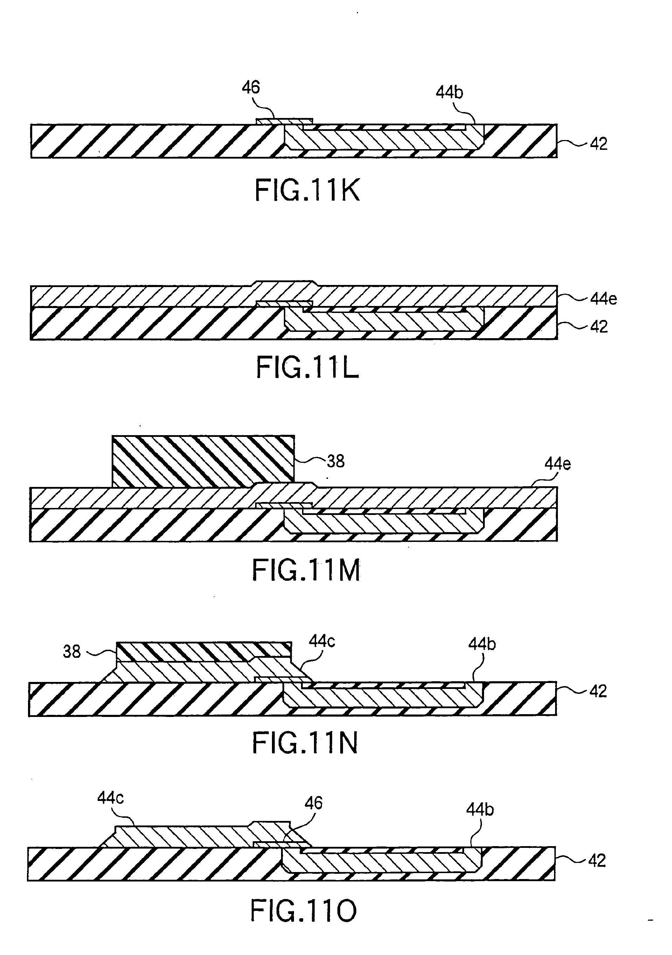

A method of manufacturing the thin film magnetic sensor 40 according to the second embodiment of the present invention will now be described. FIGS. 11A to 11O are cross sectional views collectively showing the manufacturing process of the thin film magnetic sensor according to the second embodiment of the present invention. The manufacturing process according to the second embodiment of the present invention comprises the step of forming the first thin film yoke, the step of forming the GMR film, the step of forming the second thin film yoke, the step of forming the electrodes, and the step of forming the surface protective film.

First of all, the step of forming the first thin film yoke will now be described. In the step of forming the first thin film yoke, a first soft magnetic thin film 44d is deposited on the surface of the insulating substrate 42, followed by forming a first thin film yoke 44b including a facing surface positioned to face a second thin film yoke. To be more specific, the first thin film yoke 44b having a facing surface, in which the inclination angle θ is 0°, can be formed by the steps described in the following.

In the first step, an antireflection film 34 is formed on the surface of the insulating substrate 42, as shown in FIG. 11A. The antireflection film 34 serves to improve the patterning accuracy in the subsequent step of patterning with photoresist, which is described herein later. In general, the antireflection film 34 is formed of, for example, a Cr thin film or a Ti thin film.

In the next step, a photoresist film 38 is formed in the region where the first thin film yoke 44b is not formed, as shown in FIG. 11B. In this case, it is desirable to apply a post baking after formation of the photoresist film 38 as in the first embodiment described previously. If the post baking is applied to the photoresist film 38, a slight inclination is formed on the side wall surface of the photoresist film 38 and, thus, the shading is unlikely to be generated in the subsequent etching stage. Also, if the etching is carried out under the optimum conditions, it is possible to etch the insulating substrate 42 in a direction substantially perpendicular to the surface of the insulating substrate 42 along the boundary line of the photoresist film 38.

In the next step, an ion beam etching is performed while rotating the insulating substrate 42, as shown in FIG. 11C. In this case, it is possible to etch the surface of the insulating substrate 42 in a direction substantially perpendicular to the surface of the insulating substrate 42 along the boundary line of the photoresist film 38 as shown in FIG. 11C, if the ion beam irradiating conditions such as the rotating speed of the insulating substrate 42 and the irradiating angle of the ion beam are optimized.

After completion of the etching treatment, the photoresist film 38 remaining on the surface of the insulating substrate 42 is removed (peeled off). As a result, a concave groove can be formed in the surface region of the insulating substrate 22, as shown in FIG. 11D. It should be noted that the side wall defining the concave groove is substantially perpendicular to the surface of the insulating substrate 42.

In the next step, a first soft magnetic thin film 44d is deposited on the entire surface of the insulating substrate 42, as shown in FIG. 11E. Then, a first protective film 30 is formed on the first soft magnetic thin film 44d, as shown in FIG. 11F, followed by removing by, for example, the mechanical polishing method or the etch back method the unnecessary portion of the first soft magnetic thin film 44d excluding the portion deposited within the concave groove and positioned below the surface of the insulating substrate 42. As a result, obtained is the first thin film yoke 44b in which the inclination angle θ of the facing surface is substantially 0°, as shown in FIG. 11G. Incidentally, it is possible for the first protective film 30 to be removed completely or to be partly left unremoved at the time when the unnecessary portion of the first soft magnetic thin film 44d is removed.

The step of forming the GMR film will now be described. In the step of forming the GMR film, the GMR film 46 is formed on the facing surface of the first thin film yoke 44b. It should be noted that the method of forming the GMR film 46 is substantially equal to the method of forming the GMR film 26 included in the thin film magnetic sensor 20 according to the first embodiment of the present invention described previously.

In the first step, the GMR film 46 having a prescribed composition is deposited in a prescribed thickness on the entire surface of the insulating film 42 having the first thin film yoke 44b formed thereon, as shown in FIG. 11H. Then, a photoresist film 38 is formed on the facing surface of the first thin film yoke 44b and on the surface in the vicinity of the facing surface noted above, as shown in FIG. 11I. Further, an ion beam etching is performed under a prescribed condition so as to remove the unnecessary portion of the GMR film 46, as shown in FIG. 11J. After completion of the etching, the residual photoresist film 38 is removed (peeled off) so as to form the GMR film 46 on the facing surface of the first thin film yoke 44b and on the surface in the vicinity of the facing surface noted above, as shown in FIG. 11K.

Incidentally, where the lateral width of the GMR film 46 is smaller than the lateral width of the facing surface of the first thin film yoke 44b or where the width is decreased in that portion of the GMR film 46 which is brought into contact with both the first thin film yoke 44b and the second thin film yoke 44c, it is necessary to form a thin film consisting of an insulating nonmagnetic material on both sides of the GMR film 46 or in a manner to cover partly the surface of the GMR film 46 as in the first embodiment of the present invention described previously.

The step of forming the second thin film yoke will now be described. In the step of forming the second thin film yoke, a second soft magnetic thin film 44e is deposited on the surface of the insulating substrate 22 such that the GMR film 46 is brought into an electrical contact with the second thin film yoke 46c on the surface of the GMR film 46 deposited on the facing surface of the first thin film yoke 44b so as to form the second thin film yoke 44c consisting of the soft magnetic material. To be more specific, it is desirable for the step of forming the second thin film yoke to be carried out as follows.

In the first step, the second soft magnetic thin film 44e is deposited on the entire surface of the insulating substrate 42, as shown in FIG. 11L. Then, a resist film 38 is formed on that region of the second magnetic thin film 44e which is to be left unremoved, as shown in FIG. 11M. In this case, it is desirable for the resist film 38 to be formed to extend to reach substantially the center of the facing surface of the first thin film yoke 44b. In this case, the electrical resistance of the GMR film 46 is defined by the distance from the edge of the first thin film yoke 44b.

In the next step, an Ar ion beam etching is performed under a prescribed condition while rotating the insulating substrate 22, as shown in FIG. 11N. The etching is performed until at least the portion where the first thin film yoke 44b is in direct contact with the second thin film yoke 44c is removed. If the etching condition is optimized in this stage, the second soft magnetic thin film 44e is obliquely etched along the boundary line of the photoresist film 38 so as to remove completely that portion of the second soft magnetic thin film 44e which is in contact with the first thin film yoke 44b. Also, if the etching condition is optimized, it is possible to achieve the patterning such that the shape of the GMR film 46 is substantially equal to that at the tip portion of the second thin film yoke 44c even in the case where the lateral width of the GMR film 46 as formed is larger than the lateral width in the tip portion of the second thin film yoke 44c. After completion of the etching, the residual photoresist film 38 is removed (peeled off) so as to obtain the first thin film yoke 44b including the facing surface having a prescribed inclination angle θ, the GMR film 46 deposited on the facing surface noted above, and the second thin film yoke 44c that is brought into an electrical contact with the GMR film 46 on the surface of the GMR film 46, as shown in FIG. 11O.

Further, the electrodes 48b and 48c are formed in the edge portions of the first thin film yoke 44b and the second thin film yoke 44c, respectively, followed by forming the second protective film 52 on the entire surface of the insulating substrate 42 in accordance with the procedures similar to those in the first embodiment of the present invention so as to obtain the thin film magnetic sensor 40 according to the second embodiment of the present invention.

The function and effect of the thin film magnetic sensor 40 according to the second embodiment of the present invention will now be described. It is possible to obtain the first thin film yoke 44b including the facing surface that is parallel to the surface of the insulating substrate 42, if a concave groove is formed in a surface region of the insulating substrate 42, followed by depositing the first soft magnetic thin film 44d on the entire surface and subsequently removing selectively the first soft magnetic thin film 44d except the portion positioned within the concave groove formed in the insulating substrate 42.

In the next step, the GMR film 46 is deposited on the facing surface of the first thin film yoke 44b, followed by further forming the second thin film yoke 44c on the GMR film 46. As a result, the second thin film yoke 44c can be brought into an electrical contact with the GMR film 46 on the surface of the GMR film 46.

In the thin film magnetic sensor 40 thus manufactured, the first thin film yoke 44b and the second thin film yoke 44c, which are positioned to face each other with a gap interposed therebetween, are brought into a face contact with each other without fail via the surface of the GMR film 46 so as to stabilize the magnetic characteristics of the thin film magnetic sensor 40. In addition, since the gap length is defined by the thickness of the GMR film 46, it is possible to suppress the dispersion into the air atmosphere of the magnetic flux leaking from the first thin film yoke 44b and the second thin film yoke 44c. It follows that the thin film magnetic sensor 40 exhibits a high sensitivity to the magnetic field.

It should also be noted that, since the facing surface of the first thin film yoke 44b is parallel to the surface of the insulating substrate 42 in the thin film magnetic sensor 40 according to the second embodiment of the present invention, the facing surface of the first thin film yoke 44b can be formed very easily. It is also possible to form very easily the GMR film 46 on the facing surface of the first thin film yoke 44b. It follows that the thin film magnetic sensor 40 exhibiting stable magnetic characteristics can be manufactured at a low cost and with a high reproducibility.

### Third Embodiment

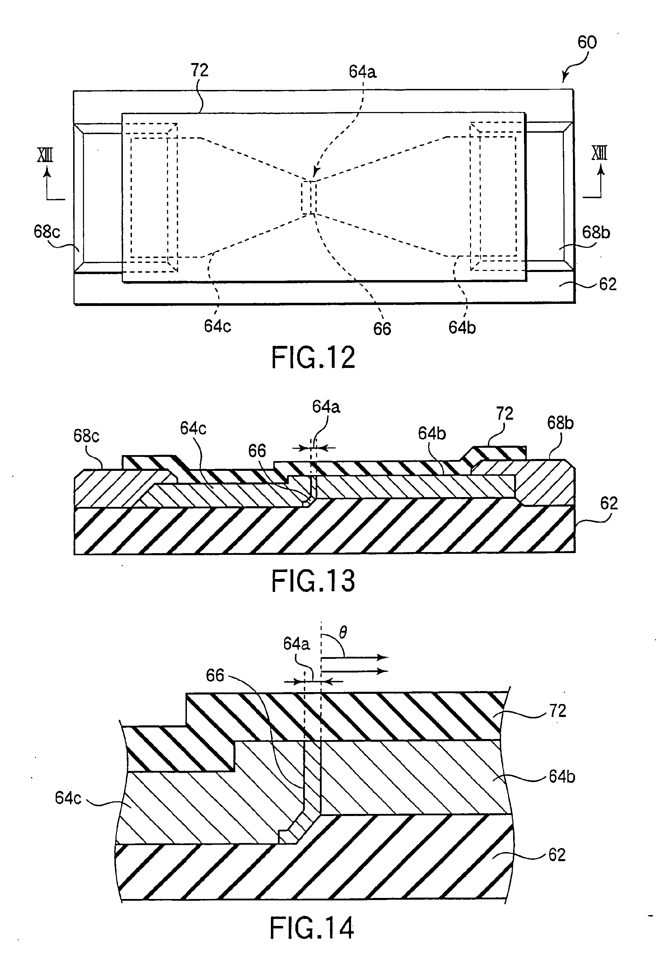

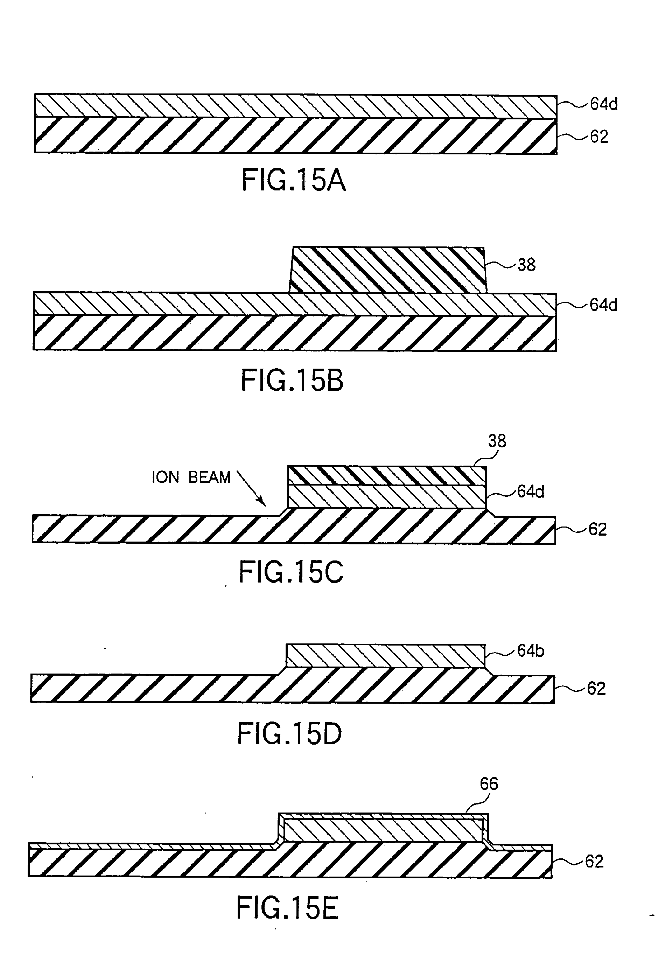

A thin film magnetic sensor according to a third embodiment of the present invention will now be described. FIG. 12 is a plan view schematically showing the construction of a thin film magnetic sensor 60 according to a third embodiment of the present invention, FIG. 13 is a cross sectional view along the line XIII-XIII shown in FIG. 12, and FIG. 14 is a cross sectional view showing in a magnified fashion the region in the vicinity of the gap included in the thin film magnetic sensor according to the third embodiment of the present invention.

As shown in the drawings, the thin film magnetic sensor 60 comprises an insulating substrate 60, a pair of first thin film yoke 64b and second thin film yoke 64c, which are positioned to face each other with a gap 64a interposed therebetween, and a GMR film 66 formed in the gap 64a so as to be electrically connected to the first thin film yoke 64b and the second thin film yoke 64c. Electrodes 68b and 68c are connected to the edge portions of the first thin film yoke 64b and the second thin film yoke 64c, respectively, and the uppermost surface of the insulating substrate 62 is covered with a second protective film 72.

The thin film magnetic sensor 60 according to the third embodiment of the present invention is featured in that the facing surface of the first thin film yoke 64b is substantially perpendicular to the surface of the insulating substrate 62. In other words, the facing surface is formed on the vertical edge surface of the first thin film yoke 64b. Also, the inclination angle θ of the facing surface of the first thin film yoke 64b is 90°, i.e., the inflow angle φ is 0°.

Incidentally, the insulating substrate 62, the first thin film yoke 64b, the second thin film yoke 64c, the GMR film 66, the electrodes 68b and 68c, the second protective film 72 and the other members are equal to the insulating substrate 22, the first thin film yoke 24b, the second thin film yoke 24c, the GMR film 26, the electrodes 28b and 28c, the second protective film 32 and the other members included in the thin film magnetic sensor 20 according to the first embodiment of the present invention and, thus, the description of the insulating substrate 62, etc. is omitted.

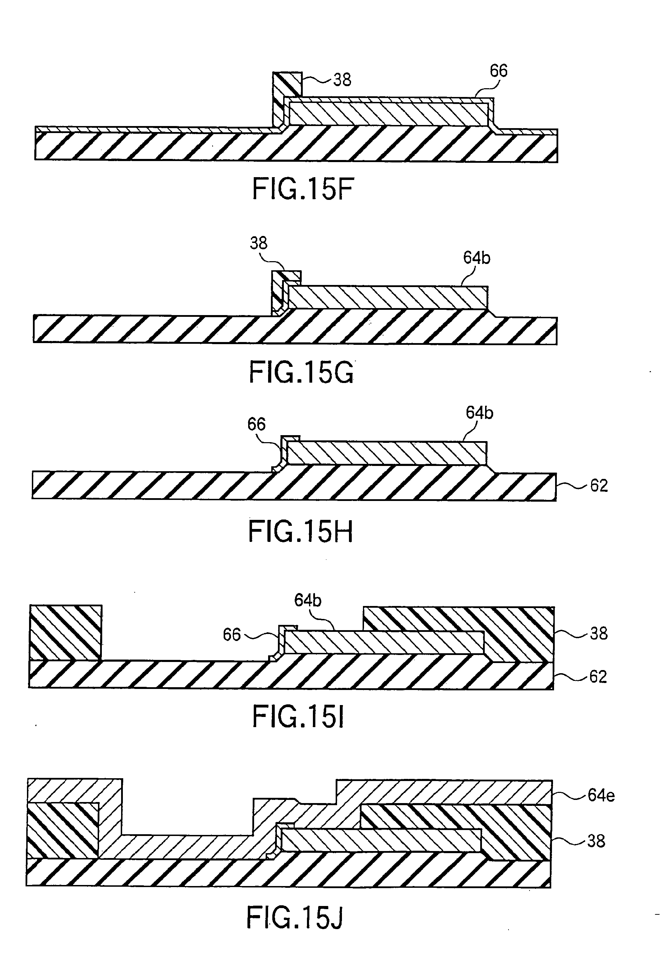

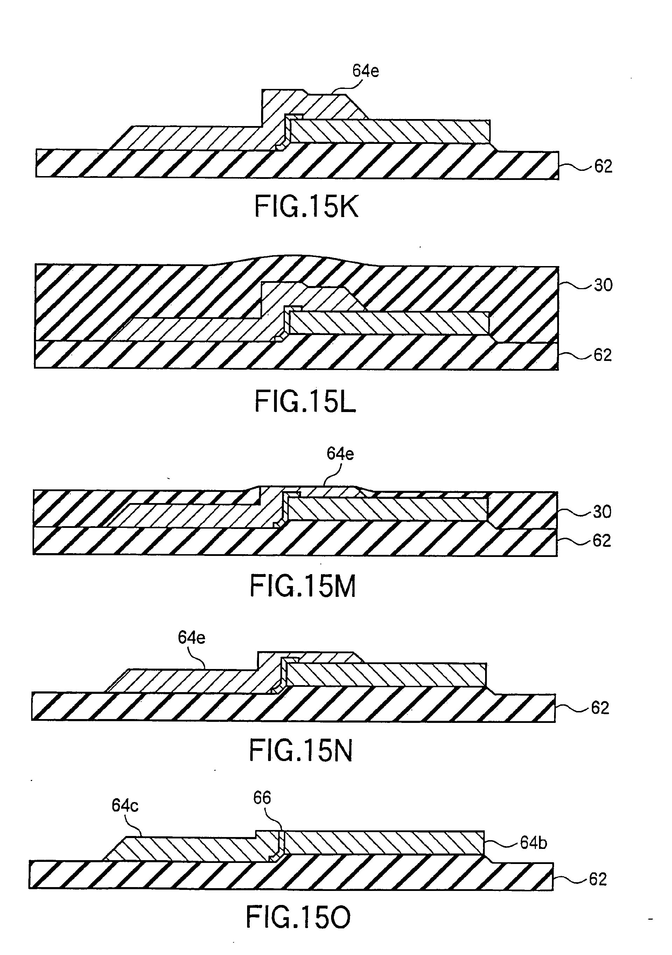

The manufacturing process of the thin film magnetic sensor 60 according to the third embodiment of the present invention will now be described. FIGS. 15A to 15O are cross sectional views collectively showing the manufacturing process of the thin film magnetic sensor according to the third embodiment of the present invention. The manufacturing process for this embodiment comprises the step of forming a first thin film yoke, the step of forming a GMR film, the step of forming a second thin film yoke, the step of forming an electrode, and the step of forming a surface protective film.

The thin film magnetic sensor 60 according to the third embodiment of the present invention is featured in that the inclination angle θ in the facing surface of the first thin film yoke 64b is 90°. The particular thin film magnetic sensor 60 can be manufactured by simply changing the etching conditions in the step of removing by etching the first soft magnetic thin film 64d deposited on the surface of the insulating substrate 62. The manufacturing method of the thin film magnetic sensor 60 is equal in the other respects to the manufacturing method of the thin film magnetic sensor 20 according to the first embodiment of the present invention.

In manufacturing the thin film magnetic sensor 60, the first soft magnetic thin film 64d is deposited in the first step on the entire surface of the insulating substrate 62, as shown in FIG. 15A. Then, a photoresist film 38 is formed in the region where the first thin film yoke 64b is to be formed, as shown in FIG. 15B. In this case, it is desirable to apply a post baking to the photoresist film 38 as in the first embodiment described previously.

In the next step, an Ar ion beam etching is performed under a prescribed condition while rotating the insulating substrate 62. If the etching condition is optimized in this step, it is possible to etch the first soft magnetic thin film 64d in a direction substantially perpendicular to the surface of the insulating substrate 62 along the boundary line of the photoresist film 38, as shown in FIG. 15C. After completion of the etching, the residual photoresist film 38 is removed (peeled off) so as to obtain the first thin film yoke 64b having an inclination angle of 90°, as shown in FIG. 15D.

In the next step, the GMR film 66 is deposited on the entire surface of the insulating substrate 62, as shown in FIG. 15E, followed by newly forming a photoresist film 38 on the facing surface of the first thin film yoke 64b, i.e., the edge surface facing the second thin film yoke that is to be formed later, and on the surface in the vicinity of the facing surface noted above, as shown in FIG. 15F. Further, the unnecessary portion of the GMR film 66 is removed by the ion beam etching, as shown in FIG. 15G, followed by removing (peeling off) the residual photoresist film 38, as shown in FIG. 15H. As a result, the GMR film 66 is formed on the facing surface having an inclination angle of 90°.

In the next step, a photoresist film 38 is newly formed on the surface of the insulating substrate 62 excluding the portion where the second thin film yoke 64c is to be formed, as shown in FIG. 15I. In this case, it is desirable to form the photoresist film 38 in a manner to permit a second soft magnetic thin film 64e to be deposited in the subsequent step on the first thin film yoke 64b, too, as in the first embodiment described previously. Then, the second soft magnetic thin film 64e is deposited in a prescribed thickness on the entire surface of the insulating substrate 62, as shown in FIG. 15J, followed by lifting off the photoresist film 38, as shown in FIG. 15K.

In the next step, a first protective film 30 is formed on the entire surface of the insulating substrate 62, as shown in FIG. 15L. Then, the unnecessary portion of the second soft magnetic thin film 64e is removed by the mechanical polishing method or by the etch back method, i.e., by repeating a prescribed number of times the operations of forming the first protective film 30 as shown in FIG. 15L, etching the first protective film 30 as shown in FIG. 15M, and removing (peeling off) the residual first protective film 30 as shown in FIG. 15N. As a result, obtained is the second thin film yoke 64c electrically connected to the GMR film 66 on the surface of the GMR film 66, as shown in FIG. 150.

Further, the electrodes 68b and 68c are formed in the edge portions of the first thin film yoke 64b and the second thin film yoke 64c, respectively, (electrode forming step), followed by forming the second protective film 72 on the entire surface of the insulating substrate 62 (surface protective film forming step) in accordance with the procedures equal to those employed in the first embodiment of the present invention described previously so as to obtain the thin film magnetic sensor 60 according to the third embodiment of the present invention.

The function and effect of the thin film magnetic sensor 60 according to the third embodiment of the present invention will now be described. It is possible to obtain the first thin film yoke 64b, in which the inclination angle θ of the facing surface is 90°, if the first soft magnetic thin film 64d is deposited on the surface of the insulating substrate 62, followed by removing the unnecessary portion of the first soft magnetic thin film 64d under a prescribed condition. After formation of the first thin film yoke 64b, the GMR film 66 is deposited on the facing surface of the first thin film yoke 64b, followed by further depositing the second thin film yoke 64c. As a result, the second thin film yoke 64c is electrically connected to the GMR film 66 on the surface of the GMR film 66.

In the thin film magnetic sensor 60 thus manufactured, a face contact is achieved without fail between the first thin film yoke 64b and the second thin film yoke 64c, which are positioned to face each other with the gap 64a interposed therebetween. To be more specific, the face contact noted above is achieved via the surfaces of the GMR film 66. As a result, the magnetic characteristics of the thin film magnetic sensor 60 can be stabilized. In addition, since the gap length is defined by the thickness of the GMR film 66, it is possible to suppress the dispersion into the air atmosphere of the magnetic flux leaking from the first thin film yoke 64b and the second thin film yoke 64c. It follows that the thin film magnetic sensor 60 is allowed to exhibit a high sensitivity to the magnetic field. What should also be noted is that, since the GMR film 66 extends in the direction perpendicular to the flowing direction of the magnetic flux, it is possible to suppress more effectively the dispersion into the air atmosphere of the magnetic flux leaking from the first thin film yoke 64b and the second thin film yoke 64c so as to enable the thin film magnetic sensor 60 to exhibit a higher sensitivity to the magnetic field.

### EXAMPLES

### (Example 1)

A thin film magnetic sensor 20 according to the first embodiment of the present invention, which was constructed as shown in FIGS. 4 to 6, was manufactured by the manufacturing process shown in FIG. 7A to 7V. Incidentally, a non-alkali glass substrate was used as the insulating substrate 22. A metal-insulator system nano granular material having a composition of FeCo-MgF₂ was used for forming the GMR film 26. Further, a CoFeSiB amorphous material was used for forming each of the first thin film yoke 24b and the second thin film yoke 24c. Each of the first thin film yoke 24b and the second thin film yoke 24c had a thickness of 1.0 µm, and the length of the gap between the first thin film yoke 24b and the second thin film yoke 24c, i.e., the thickness of the GMR film 26, was 0.2 µm. Incidentally, 5 samples, i.e., samples Nos. 1 to 5, were prepared for the thin film magnetic sensor 20.

### (Example 2)

A thin film magnetic sensor 40 according to the second embodiment of the present invention, which was constructed as shown in FIGS. 8 to 10, was manufactured by the manufacturing process shown in FIG. 11A to 11O. Incidentally, the conditions for Example 2 were equal to those for Example 1, except that the gap length was set at 0.25 µm, and that 2 samples, i.e., samples Nos. 6 and 7, were prepared for the thin film magnetic sensor 40.

### (Example 3)

A thin film magnetic sensor 60 according to the third embodiment of the present invention, which was constructed as shown in FIGS. 12 to 14, was manufactured by the manufacturing process shown in FIG. 15A to 150. Incidentally, the conditions for Example 3 were equal to those for Example 1, except that the gap length was set at 0.12 to 0.15 µm, and that 3 samples, i.e., samples Nos. 8 to 10, were prepared for the thin film magnetic sensor 60.

### (Comparative Example 1)

A thin film magnetic sensor 10 constructed as shown in FIGS. 1 to 3 was manufactured as follows. Specifically, a soft magnetic thin film consisting of a CoFeSiB amorphous material was deposited in a thickness of 1.0 µm on the surface of an insulating substrate 12 formed of a non-alkali glass substrate. Then, the soft magnetic thin film was etched so as to form thin film yokes 14 positioned to face each other with a gap (groove) 14a having a gap length of 2.0 µm interposed therebetween.

In the next step, a GMR film 16 consisting of a metal-insulator system nano granular material having a composition of FeCo-MgF₂ was deposited in a thickness of 0.5 µm on the bottom wall and the side walls of the gap 14a with a mask formed to cover the surface of the insulating substrate 12 except the region of the gap 14a. Further, electrodes 18 and 18 were formed in the edge portions of the thin film yokes 14, followed by further forming a protective film 19 in a manner to cover the upper surfaces of the thin film yokes 14 and the GMR film 16 so as to obtain a thin film magnetic sensor 10. Incidentally, 5 samples, i.e., samples Nos. 11 to 15, were prepared for the thin film magnetic sensor 10 for Comparative Example 1.

The MR ratio (%) was measured under 5 Oe in respect of the thin film magnetic sensor obtained in each of Examples 1 to 3 and Comparative Example 1. Table 1 shows the results.

**Table 1**

| Sample No. | Gap Length (µm) | MR Ratio (%) at 5 Oe |
|---|---|---|
| 1 | 0.2 | 8.6 |
| 2 | 0.2 | 9.2 |
| 3 | 0.2 | 8.8 |
| 4 | 0.2 | 9.5 |
| 5 | 0.2 | 9.1 |
| 6 | 0.25 | 5.5 |
| 7 | 0.25 | 6.0 |
| 8 | 0.15 | 9.8 |
| 9 | 0.15 | 10.2 |
| 10 | 0.12 | 11.0 |
| 11 | 2.0 | 1.0 |
| 12 | 2.0 | 4.0 |
| 13 | 2.0 | 2.2 |
| 14 | 2.0 | 1.8 |
| 15 | 2.0 | 3.5 |

As shown in Table 1, the thin film magnetic sensors for Comparative Example 1 (samples Nos. 11 to 15) were found to have small absolute values of the MR ratio, and the nonuniformity of the absolute values of the MR ratio was large (1.0 to 4.0%). On the other hand, the thin film magnetic sensors for Examples 1, 2 and 3 of the present invention (sample Nos. 1 to 10) were found to have large absolute values of the MR ratio. To be more specific, the absolute values of the MR ratio for Examples 1, 2 and 3 were found to be 8.6 to 9.5%, 5.5 to 6.0%, and 9.8 to 11.0%, respectively, which were much larger than that for Comparative Example 1. In addition, it has been confirmed that the manufacturing method of the present invention permits stably manufacturing the thin film magnetic sensor having a large MR ratio.

The present invention is not limited at all to the embodiments described above, and various modifications can be achieved within the technical scope of the present invention.

For example, the element of the present invention comprising a GMR film and thin film yokes arranged on both sides of the GMR film is particularly suitable for use as a magnetic sensor. However, the use of the element of the present invention is not limited to the use as a magnetic sensor. It is also possible to use the element of the present invention as, for example, a magnetic memory or a magnetic head.

Also, in order to suppress the dispersion into the air atmosphere of the magnetic flux leaking from the thin film yoke, it is desirable for the inflow angle φ to be not larger than 90°. However, it is possible for the inflow angle φ to be larger than 90°. In this case, the dispersion of the magnetic flux into the air atmosphere is increased and, thus, the sensitivity to the magnetic field is somewhat lowered, compared with the case where the inflow angle φ is not larger than 90°. However, since the gap length is defined in the present invention by the thickness of the GMR film, it is possible to decrease markedly the gap length. It follows that the magnetic flux acts effectively on the GMR film, compared with the conventional thin film magnetic sensor, so as to make it possible to obtain a high sensitivity to the magnetic field.

It should also be noted that the facing surface of the first thin film yoke having an inflow angle φ exceeding 90° can be obtained by changing appropriately the manufacturing conditions such as the etching conditions of the insulating substrate, the thickness of the soft magnetic thin film deposited on the surface of the insulating substrate, and the etching conditions of the soft magnetic thin film.

The embodiments described above are simply intended to clarify the technical concept of the present invention. Of course, the present invention should not be limited to the embodiments described above in interpreting the technical scope of the present invention. The present invention can be worked in variously modified fashions within the spirit of the present invention and within the scope defined by the accompanying claims. Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A thin film magnetic sensor, comprising:
a pair of first thin film yoke and second thin film yoke each formed of a soft magnetic material, the first and second thin film yokes being positioned to face each other with a gap interposed therebetween;
a GMR film having an electrical resistivity higher than that of the soft magnetic material and formed in the gap so as to be electrically connected to the first thin film yoke and the second thin film yoke; and
an insulating substrate made of an insulating nonmagnetic material and serving to support the first thin film yoke, the second thin film yoke and the GMR film;
wherein the GMR film is formed on a facing surface of the first thin film yoke positioned to face the second thin film yoke, and the length of the gap is defined by the thickness of the GMR film positioned on the facing surface of the first thin film yoke facing the second thin film yoke.

2. The thin film magnetic sensor according to claim 1, wherein the angle made between the facing surface of the first thin film yoke and the surface of the substrate falls within a range of between 0° and 90°.

3. The thin film magnetic sensor according to claim 1, wherein the GMR film is formed of a metal-insulator system nano granular material.

4. A thin film magnetic sensor, comprising a pair of first thin film yoke and second thin film yoke each formed of a soft magnetic material, the first and second thin film yokes being positioned to face each other with a gap interposed therebetween; a GMR film having an electrical resistivity higher than that of the soft magnetic material and formed in the gap so as to be electrically connected to the first thin film yoke and the second thin film yoke; and an insulating substrate made of an insulating nonmagnetic material and serving to support the first thin film yoke, the second thin film yoke and the GMR film; the thin film magnetic sensor being obtained by the steps of:
(a) forming on the surface of the insulating substrate the first thin film yoke made of the soft magnetic material and including a facing surface positioned to face the second thin film yoke;
(b) depositing the GMR film on the facing surface of the first thin film yoke in a manner to permit the GMR film to be electrically connected to the first thin film yoke; and
(c) forming on the surface of the insulating substrate the second thin film yoke made of the soft magnetic material in a manner to permit the second thin film yoke to be electrically connected to the GMR film on the surface of the GMR film.

5. The thin film magnetic sensor according to claim 4, wherein the angle made between the facing surface of the first thin film yoke facing the second thin film yoke and the surface of the substrate falls within a range of between 0° and 90°.

6. The thin film magnetic sensor according to claim 4, wherein the GMR film is formed of a metal-insulator system nano granular material.

7. A method of manufacturing a thin film magnetic sensor, comprising the steps of:
forming on the surface of an insulating substrate made of an insulating nonmagnetic material a first thin film yoke made of a soft magnetic material and having a facing surface positioned to face a second thin film yoke that is to be formed later;
depositing on the facing surface of the first thin film yoke a GMR film having an electrical resistivity higher than that of the soft magnetic material in a manner to permit the GMR film to be electrically connected to the first thin film yoke; and
forming the second thin film yoke made of the soft magnetic material on the surface of the insulating substrate in a manner to permit the second thin film yoke to be electrically connected to the GMR film on the surface of the GMR film.

8. The method according to claim 7, wherein the first thin film yoke is formed such that the angle made between the facing surface of the first thin film yoke facing the second thin film yoke and the surface of the insulating substrate falls within a range of between 0° and 90°.

9. The method according to claim 7, further comprising the step of forming electrodes in the edge portions of the first thin film yoke and the second thin film yoke.

10. The method according to claim 7, wherein the first thin film yoke is formed by depositing a first thin film made of a soft magnetic material on the surface of the insulating substrate, followed by forming the facing surface positioned to face the second thin film yoke.

11. The method according to claim 7, wherein the second thin film yoke is formed by depositing a second thin film made of the soft magnetic material on the surface of the insulating substrate in a manner to permit the GMR film and the second thin film yoke to be electrically connected to each other on the surface of the GMR film deposited on the facing surface of the first thin film yoke facing the second thin film yoke.
